Europäisches Patentamt

European Patent Office

Office européen des brevets

(19)

(11) Veröffentlichungsnummer: **0 379 616**

**A1**

(12) **EUROPÄISCHE PATENTANMELDUNG**

(21) Anmeldenummer: **89101355.9**

(51) Int. Cl.⁵: **H01L 25/18, H01L 25/07**

(22) Anmeldetag: **26.01.89**

(43) Veröffentlichungstag der Anmeldung:
**01.08.90 Patentblatt 90/31**

(84) Benannte Vertragsstaaten:
**AT BE CH DE ES FR GB GR IT LI LU NL SE**

(71) Anmelder: **Siemens Aktiengesellschaft
Wittelsbacherplatz 2
D-8000 München 2(DE)**

(72) Erfinder: **Huber, Peter
Unertlstrasse 22
D-8000 München 40(DE)**

(54) **Halbleiterbauelement mit übereinander montierten Halbleiterkörpern.**

(57) Wird die Oberseite (4) eines ersten Halbleiterkörpers (3) mit der Unterseite (6) eines zweiten Halbleiterkörpers (5) verklebt und gemeinsam mit einer Kunststoffmasse (9) umpresst, so kann es nach lastwechseln zu Fuktionsstörungen in demjenigen Halbleiterkörper kommen (3, 5) dessen Halbleiterstrukturen sich auf der verklebten Seite befinden. Dies wird dadurch verhindert, daß die Unterseite des anderen Halbleiterkörpers mit einer duktilen Metallschicht z. B. aus Aluminium versehen ist.

FIG 1

EP 0 379 616 A1

## Halbleiterbauelement mit übereinander montierten Halbleiterkörpern

Die Erfindung bezieht sich auf ein Halbleiterbauelement mit mindestens zwei Halbleiterkörpern mit je einer oberen und einer unteren Hauptfläche, bei dem die obere, Halbleiterstrukturen aufweisende Hauptfläche des ersten Halbleiterkörpers und die untere Hauptfläche des zweiten Halbleiterkörpers elektrisch gegeneinander isoliert und über eine Kleberschicht thermisch leitend miteinander verbunden sind.

Ein solches Halbleiterbauelement ist z. B. in der DE-AI-35 24 517 beschrieben worden. Hierbei enthält der erste Halbleiterkörper einen Leistungs-MOSFET mit einer Vielzahl von einzelnen, einander parallel geschalteten Transistorzellen. Der zweite Halbleiterkörper enthält einen Temperatursensor, der den Leistungs-MOSFET bei Übertemperatur abschaltet. Er kann jedoch auch eine den Leistungs-MOSFET steuernde integrierte Schaltungsanordnung enthalten, die ihrerseits unter anderem einen Temperatursensor aufweist. Die Hauptflächen können entweder durch die Kleberschicht selbst oder durch eine zwischen Kleberschicht und der oberen Hauptfläche des unteren Halbleiterkörpers liegende Isolierschicht, z. B. aus Siliziumnitrid $Si_3N_4$ gegeneinander isoliert werden.

Wird die beschriebene Anordnung mit einer Kunststoffmasse umpresst und Lastwechseln ausgesetzt, so zeigt sich, daß diejenigen Halbleiterstrukturen des unteren Halbleiterkörpers, die vom oberen Halbleiterkörper bedeckt sind, zerstört werden können. Dies äußert sich beispielsweise in einer Erhöhung des Durchlaßwiderstandes und der Abschaltzeit des Leistungs-MOSFET. Als Ursache für die Zerstörung wurde erkannt, daß sich Rauhigkeiten der unteren Hauptfläche des oberen Halbleiterkörpers durch die Kleberschicht durchdrücken und die Halbleiterstrukturen in der oberen Hauptfläche des unteren Halbleiterkörpers beschädigen. Eine Ver stärkung der Kleberdicke schafft hier keine Abhilfe, da damit der thermische Widerstand zu groß wird.

Ziel der Erfindung ist es, ein Halbleiterbauelement der genannten Art so weiterzubilden, daß eine Zerstörung der erwähnten Halbleiterstrukturen insbesondere dann vermieden wird, wenn die Halbleiterkörper gemeinsam mit einer Vergußmasse umpreßt sind.

Dieses Ziel wird dadurch erreicht, daß die untere Hauptfläche des zweiten Halbleiterkörpers mit einer Schicht eines duktilen Metalls versehen ist.

Unter duktil soll hier "plastisch verformbar" verstanden werden.

Weiterbildungen der Erfindung sind Gegenstand der Unteransprüche.

Die Erfindung wird anhand zweier Ausführungsbeispiele in Verbindung mit den Figuren näher erläutert.

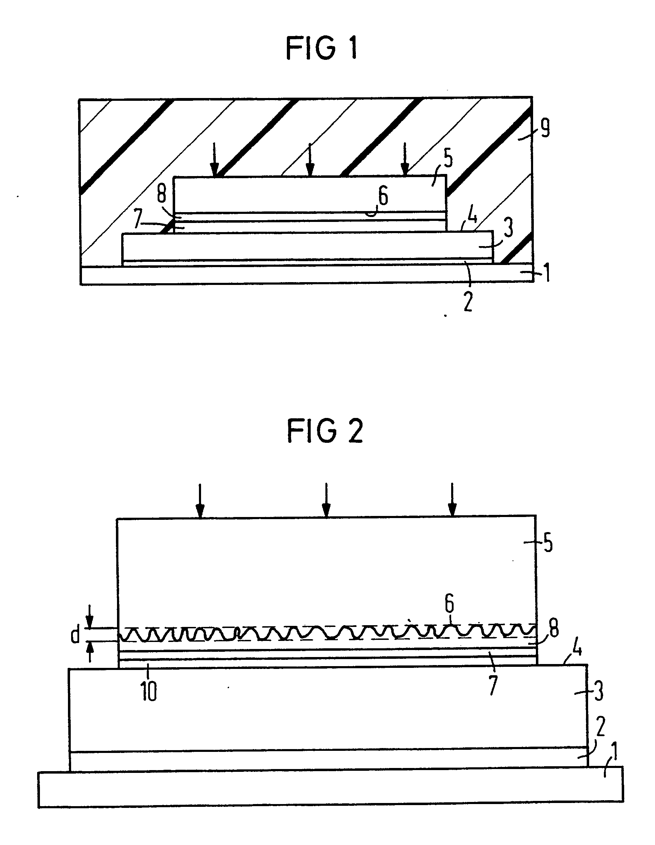

Das Halbleiterbauelement nach FIG 1 hat eine metallene Bodenplatte 1, auf der ein erster Halbleiterkörper 3 angeordnet ist. Er ist mit der Bodenplatte 1 z. B. über eine Lotschicht 2 oder einen thermisch leitfähigen Kleber verbunden. Auf der oberen Hauptfläche 4 des ersten Halbleiterkörpers 3 ist ein zweiter Halbleiterkörper 5 angeordnet. Der zweite Halbleiterkörper 5 hat eine untere Hauptfläche 6, die mit einer duktilen Metallschicht 18 versehen ist. Diese Schicht kann beispielsweise aus Aluminium, Indium oder aus Gold bestehen. Der zweite Halbleiterkörper 5 mit der Metallschicht 8 ist mit der Hauptfläche 4 über eine Kleberschicht 7 verbunden. Die Kleberschicht wirkt elektrisch isolierend und ist so dünn, z. B. einige $\mu$m, daß der Wärmefluß vom Halbleiterkörper 3 zum Halbleiterkörper 5 nur wenig behindert wird. Die verklebten Halbleiterkörper 3, 5 werden gemeinsam mit einer Kunststoff-Preßmasse 9 umpresst, die ein Gehäuse 9 für das Halbleiterbauelement bildet. Der Einfachheit halber wurden in der FIG I sämtliche elektrische Verbindungen weggelassen. Beispiele für die elektrische Verknüpfung zwischen oberem und unterem Halb leiterkörper und für deren elektrische Funktion finden sich z. B. in der erwähnten DE-AI-35 24 517 und in der DE-AI-36 32 190.

Vorteilhafterweise ist die duktile Metallschicht 8 dicker als die Rauhigkeit der unteren Hauptfläche 6 des oberen Halbleiterkörpers 5. Dies ist in FIG 2 schematisch mit starker vertikaler Überhöhung dargestellt. Die untere Hauptfläche 6 von 5 habe eine Rauhigkeit, z. B. durch Schleifen oder Sandstrahlen, die mit d bezeichnet ist. Es ist ersichtlich, daß die Dicke der duktilen Metallschicht 8 größer als d ist. Im allgemeinen wird die duktile Metallschicht 8 der Rauhigkeit der unteren Hauptfläche von 5 in etwa folgen. Da das Metall jedoch plastisch verformbar ist, werden die Unebenheiten durch die durch das Kunststoffgehäuse 9 bei Lastwechseln ausgeübten, durch die Pfeile angedeuteten vertikalen Kräfte in etwa ausgeglichen. Sie können damit die Kleberschicht 7 nicht mehr durchstoßen.

Zwischen der Kleberschicht 7 und der Hauptfläche 4 des Halbleiterkörpers 3 kann noch eine Isolierschicht aus Siliziumdioxid $SiO_2$ oder Siliziumnitrid $Si_3N_4$ liegen. Damit kann auch ein Leitkleber für die Klebeschicht 7 verwendet werden.

## Ansprüche

1. Halbleiterbauelement mit mindestens zwei Halbleiterkörpern (3, 5) mit je einer oberen und einer unteren Hauptfläche, bei dem die obere, Halbleiterstrukturen aufweisende Hauptfläche (4) des ersten Halbleiterkörpers (3) und die untere Hauptfläche (6) des zweiten Halbleiterkörpers (5) elektrisch gegeneinander isoliert und über eine Kleberschicht (7) thermisch leitend miteinander verbunden sind,

**dadurch gekennzeichnet,** daß die untere Hauptfläche (6) des zweiten Halbleiterkörpers (5) mit einer Schicht (8) eines duktilen Metalls versehen ist.

2. Halbleiterbauelement nach Anspruch 1, **dadurch gekennzeichnet,** daß die duktile Metallschicht aus Aluminium besteht.

3. Halbleiterbauelement nach Anspruch 1, **dadurch gekennzeichnet,** daß die duktile Metallschicht aus Gold besteht.

4. Halbleiterbauelement nach Anspruch 1, **dadurch·gekennzeichnet,** daß die duktile Metallschicht aus Indium besteht.

5. Halbleiterbauelement nach Anspruch 1, **dadurch gekennzeichnet,** daß die untere Hauptfläche (6) des ersten Halbleiterkörpers (5) rauh ist und daß die Dicke der duktilen Metallschicht (8) größer als die Rauhtiefe (d) ist.

6. Halbleiterbauelement nach einem der Ansprüche 1 bis 5, **dadurch gekennzeichnet,** daß der erste Halbleiterkörper (3) einen Leistungs-MOSFET und der zweite Halbleiterkörper (5) einen Temperatursensor enthält.

7. Halbleiterbauelement nach Anspruch 1, **dadurch gekennzeichnet,** daß zwischen der Kleberschicht (7) und der oberen Grenzfläche (4) des ersten Halbleiterkörpers (3) eine Isolierschicht (10) liegt.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 262 530 (SIEMENS) <br> * Patentansprüche 1,4 * | 1 | H 01 L 25/18 <br> H 01 L 25/07 |
| A | | 6,7 | |
| | --- | | |
| Y | WO-A-8 000 642 (BBC) <br> * Patentanspruch 1 * | 1 | |
| | --- | | |
| A | GB-A-1 569 437 (MARCONI) <br> * Patentanspruch 1 * | 5 | |
| | --- | | |
| A | GB-A-1 288 902 (VARO) <br> * Patentansprüche 5,6 * | 1 | |
| | --- | | |
| A | EP-A-0 255 644 (SIEMENS) <br> * Patentanspruch 1 * | 1,3 | |
| | --- | | |
| A | EP-A-0 182 008 (MITSUBISHI) <br> * Seite 3, Zeilen 18-25 * | 1,2 | |
| | --- | | |
| D,A | EP-A-0 208 970 (SIEMENS) <br> ----- | | |

|  |  |
|---|---|
| | RECHERCHIERTE SACHGEBIETE (Int. Cl.5) |
| | H 01 L |

Der vorliegende Recherchenbericht wurde für alle Patentansprüche erstellt

| Recherchenort | Abschlußdatum der Recherche | Prüfer |
|---|---|---|
| DEN HAAG | 12-09-1989 | DE RAEVE R.A.L. |

EPO FORM 1503 01.82 (P0403)

KATEGORIE DER GENANNTEN DOKUMENTE

X : von besonderer Bedeutung allein betrachtet
Y : von besonderer Bedeutung in Verbindung mit einer
    anderen Veroffentlichung derselben Kategorie
A : technologischer Hintergrund
O : nichtschriftliche Offenbarung
P : Zwischenliteratur

T : der Erfindung zugrunde liegende Theorien oder Grundsatze
E : alteres Patentdokument, das jedoch erst am oder
    nach dem Anmeldedatum veroffentlicht worden ist
D : in der Anmeldung angefuhrtes Dokument
L : aus andern Grunden angefuhrtes Dokument

& : Mitglied der gleichen Patentfamilie, ubereinstimmendes
    Dokument